# EUROPEAN PATENT SPECIFICATION

(11) **EP 0 914 758 B1**
(45) Date of publication and mention of the grant of the patent: **27.10.2004**
(21) Application number: 98905569.4
(22) Date of filing: 16.03.1998
(51) Int. Cl.: H05K 5/06

(54) **METHOD OF MANUFACTURING ENVELOPED ELECTRIC, ELECTRONIC OR ELECTROMECHANICAL COMPONENTS OF SMALL DIMENSIONS**
VERFAHREN ZUR HERSTELLUNG VON UMHÜLLTEN ELEKTRISCHEN, ELEKTRONISCHEN ODER ELEKTROMAGNETISCHEN BAUELEMENTEN MIT GERINGEN AUSMASSEN
PROCEDE POUR FABRIQUER DES COMPOSANTS ELECTRIQUES, ELECTRONIQUES OU ELECTROMECANIQUES ENVELOPPES ET DE PETITES DIMENSIONS

(30) Priority: 25.04.1997 EP 97201241
(43) Date of publication of application: 12.05.1999
(73) Proprietor: Koninklijke Philips Electronics N.V., 5621 BA Eindhoven (NL)
(72) Inventor: WEEKAMP, Johannus, Wilhelmus, NL-5656 AA Eindhoven (NL)
(74) Representative: van der Veer, Johannis Leendert
(86) International application number: PCT/IB1998/000352
(87) International publication number: WO 1998/049878

(56) References cited:
- EP-A- 0 407 649
- DE-A- 3 539 518
- DE-A- 3 913 066
- US-A- 4 079 511
- US-A- 4 633 573
- US-A- 5 461 545

## Description

The invention relates to a method of manufacturing electric, electronic or electromechanical components enveloped in an electrically insulating material. The invention more particularly relates to such components of small dimensions which can suitably be mechanically mounted on a substrate provided with a conductor pattern (printed circuit board. PCB), thereby forming an electric or electronic circuit.

Such components are generally known. Said known components are leadless and are referred to as surface mountable devices (abbr. SMD). The electric contacts of such components can be used to solder said components in a simple manner onto the printed circuit. By virtue of the small dimensions of such components and the absence of leads, a high packing density of the components on the PCB can be achieved.

US-A- 4 633 573 discloses a microcircuit sealed in an insulating cavity, connected via a bond-wire to a metallised bond pad sealed between the layers of a ceramic package.

The ongoing miniaturization requires ever smaller dimensions of these components. In the case of components for mounting on a PCB, these dimensions are of the order of 1 x 0.5 x 0.5 mm. When such small components are provided by mechanical means, for example by means of placement machines, a high dimensional accuracy of the components is very important.

It is an object of the invention to provide a method by means of which electrically insulated components of small dimensions can be manufactured with great dimensional accuracy. The invention also aims at providing components which can suitably be used in such a method.

In accordance with the invention, this object is achieved, in a manner which is satisfactory in view of the current practice, by a method which is characterized in that
(a) components are provided on, or in cavities in, a plate of an electrically insulating material.
(b) after the provision of the components, the plate of an electrically insulating material is covered on one side, or if the components are situated in through-holes, on both sides with a plate of an electrically insulating material which is hermetically secured to the plate of an electrically insulating material supporting the components, thereby shutting off the components from the environment, metal films being applied to the surface of at least one of the plates so as to enable electric contact to be made with the components,
(c) the assembly is subdivided into blocks which each comprise a component enveloped in an electrically insulating material, with partition lines cutting into the metal films serving to make electric contact with the components,
(d) and, subsequently, the blocks are provided with two or more electric contacts in the form of solderable metal layers which make electric contact with the metal films projecting between the portions of the envelope, which metal films serve to make electric contact with the enveloped component.

By "cutting into the metal films" is meant, in this context, that the metal films, for example in the form of metal strips provided in accordance with a pattern, are cut through upon the subdivision into blocks, or at least contacted in such a manner that the side faces of these metal films or metal strips project sufficiently between the portions of the envelope of the blocks to form an electric connection between the enveloped components and the electric contacts to be provided on the blocks.

In the method in accordance with the invention, separately manufactured components or parts of components can be provided on the surface of a plate of an electrically insulating material or in cavities made in the surface of such a plate. It is alternatively possible, however, to build up such components on the surface of, or in cavities in, such a plate by providing suitable electrically conducting and/or semiconducting and insulating layers in accordance with a pattern. This can be achieved by means of known techniques for applying such layers, such as thin-film techniques (vapor deposition, sputtering and the like) and thick-film techniques (screen printing, printing and the like). The cavities in the plate may be small pits or blind holes in the surface or through-holes or apertures. The shape and dimension of said cavities should be selected so that they can suitably accommodate the desired component. In all cases, a patterned metal film for the electric contact with the component is provided on the surface and, if required by the shape of the component, in the blind holes or apertures of the plate or on both surfaces of the plate.

The plate may consist, for example, of a thin plate of an electrically insulating material having a thickness, for example, of 0.2 to 0.5 mm or greater or lesser to an extent compatible with the method in accordance with the invention. A material which can very suitably be used is glass. Plates of ceramic materials, such as aluminium oxide and zirconium oxide can also be used. Blind holes and through-holes or apertures can be made in the plate by means of known techniques such as powder blasting, chemical etching, laser etching and the like. If such cavities are to be provided, the plate used is preferably made of a selectively etchable type of glass.

After the plate has been provided with the components and the metal films which serve to make the electric contact, a plate of the same or a different electrically insulating material is provided on the side of the plate where the components are situated on the surface or in a cavity in the surface of the plate. If the plate has through-holes, it is covered on both sides with a plate of the same or a different electrically insulating material after the components are provided. The plates are adhered to the plate provided with components, for example with a glass frit if the plate comprising components and the covering plate(s) are made of glass. The melting temperature of such a glass frit should be lower than the melting temperature of the glass of the plates used. In addition, the components should be capable of withstanding said temperature. It is alternatively possible to employ adhesives on the basis of a synthetic resin provided that they can withstand the treatments which will be carried out in subsequent steps of the method. For specific constructions of the envelope, metal films on the plate provided with components, and on the other plate or plates serving to make electric contact with the components, can also be used as the bonding layer between the plate provided with components and the cover plate(s).

The assembly thus formed is subsequently subdivided into small blocks which each comprise at least one component enveloped in an electrically insulating material. In the subdivision process, the metal films which provide electric contact with the component(s) are cut along partition lines between the blocks. The subdivision into blocks can take place, for example, mechanically by sawing, breaking, cutting or by means of a laser and the like. These processes enable a high dimensional accuracy to be achieved.

The side faces of the metal films serving to make electric contact project locally at the side faces of the blocks between the portions of the envelope. In a subsequent step of the method in accordance with the invention, the blocks are provided with electric contacts at two locations, which contacts are electrically connected to the side faces of the metal films and hence to the actual component and, if required in view of the construction of the envelope, they may embrace the blocks. Depending on the functioning of the enveloped component in a circuit, said enveloped component may comprise more than two contacts.

The components may alternatively be accommodated in cavities which are formed by two corresponding blind holes in two plates of an electrically insulating material. To achieve this, a method in accordance with the invention is characterized in that
(a) two plates of an electrically insulating material are provided with blind holes in accordance with an identical pattern, the combined depth of said holes and the other dimensions being sufficient to accommodate a component,
(b) the plates are provided with patterned electric contact layers in the form of strips of metal films extending down to the bottom of the cavities,
(c) components are arranged in the cavities in a plate, (d) the other plate is hermetically secured, with the side provided with cavities facing the side of the plate comprising the components, to said latter plate, whereafter the resultant assembly is subdivided into blocks which are provided with electric contacts.

In an interesting modification of this embodiment of the method in accordance with the invention, components provided with end contacts at facing ends of the components, are arranged in through-holes in a supporting plate of an electrically insulating material in such a manner that each end contact of each component extends in the plane of a surface of the supporting plate or projects above said plane. Subsequently, the supporting plate with components in the through-holes is covered on both sides with plates provided with metal strips in accordance with a pattern, which serve as electrode layers and electrically contact the end contacts of the components. If the thickness of the supporting plate having through-holes is equal to the distance between contact faces of the end contacts of the components arranged in the holes, flat cover plates can be used and, after both cover plates have been arranged, the components will electrically contact the electrode layers on the surface thereof. A satisfactory electric contact can be obtained by providing the contact faces of the end contacts or the metal strips with a thin layer of a deformable metal, preferably gold, at the location where they contact the end contacts of the components.

If the distance between the contact faces of the end contacts of the components is greater than the thickness of the supporting plate, the end contacts of the components will project from the plane of the surface of the supporting plate. In this case, one or both cover plates are provided with blind holes of sufficient depth to accommodate the projecting part of the components. The metal strips are provided on the cover plates, for example, in accordance with such a pattern that after the provision of the cover plates on the supporting plate with components, each component is electrically connected to two different components in a row by means of a metal strip.

When the assembly is subdivided into blocks, with the partition faces which extend at right angles to metal strips on the longitudinal axis always cutting through the metal strips on one side or on the other side of the plate having components in the through-holes, the metal strips, which are situated on opposite sides of said part of the block accommodating the component in a through-hole, project at opposing ends of the block between the portions of the envelope. Subsequently, these ends of the block are provided with electric end contacts which, at the surface, are made of a solderable metal.

In a further preferred embodiment of the method in accordance with the invention, the sharp edges of the blocks are mechanically removed, for example by tumbling in the presence of a grinding agent, prior to the provision of the electric contacts. By virtue thereof, it is precluded that parts of the surface of the envelope chip off during subsequent treatments, such as provision of the electric contacts, measurement and sorting, and mounting of the finished enveloped components in an electric or electronic circuit.

The electric contacts may be provided, for example, by first providing the entire surface of the blocks with a metallic nucleation layer. Such a nucleation layer may consist. for example, of a nickel-chromium alloy which is provided by magnetron-sputtering (barrel-sputtering) a bulk sample in a vacuum chamber. Such a nucleation layer may alternatively be provided by vapor deposition or in a wet-chemical process. Subsequently, the blocks are provided with a removable masking layer at the locations where, in a subsequent step, a metal layer is to be provided to enable electric contact. Said masking layer may consist of a readily soluble or low-melting lacquer or wax.

Subsequently, the metallic nucleation layer is removed, for example by chemical etching, from the parts which are not covered with a masking layer, whereafter the masking layer is also removed. The exposed portions of the nucleation layer are subsequently provided, in succession, with a metal layer (by means of electrodeposition) and a solder layer (by means of dip coating). If desired, for example in view of the construction of the envelope, the electric contacts thus formed may embrace the ends of the block in order to electrically contact the metal films situated between portions of the envelope and serving, at least partly, as electric contacts of the enveloped components.

The method in accordance with the invention may be used, for example, in the manufacture of enveloped single-layer and multilayer thin-film and thick-film capacitors, thin-film and thick-film resistors, diodes, sensors (NTC), thin-film coils, safety fuses, reed contacts and the like, and combinations of such components, such as combinations of capacitors, resistors, sensors, diodes and/or transistors and the like, and the method can also be used to envelop electric and electronic circuits comprising such components. The term "component", as used in the foregoing, in the following and in the claims, should be taken to include combinations of equal and/or functionally different components and electric and electronic circuits comprising such components.

The components may be built up, completely or partly, on the plate of an electrically insulating material or they may be manufactured separately, either integrally or partly, and arranged in cavities in the plate, if necessary while forming an electric or electronic circuit, for which purpose the support is provided, in known manner, with suitable electroconductive wiring, for example by etching electroconductive tracks from a metal film in accordance with a suitable pattern.

The method in accordance with the invention provides enveloped components or combinations thereof which can readily be mounted in an electric or electronic circuit on a PCB, and the component being hermetically shut off from the environment. The enveloped components have a very good dimensional tolerance, which is achieved by the subdivision into blocks in accordance with a pattern. The envelope is properly shut off from the environment because it can be made of glass and/or a ceramic material. If necessary, the enveloped components may be subjected to a tumbling operation as a result of which the sharp edges are removed from said enveloped components. Sharp edges may break off during further treatments, such as selecting, measuring, packing, handling with bulk feeders and the like. If the ends of the envelope of the components are surrounded by the electric contacts, then a good solderability and inspectability are achieved as well as a good mechanical adhesion of the contacts to the envelope.

The enveloped electric, electronic or electromechanical components in accordance with the invention are characterized in that the component is embedded in a hermetic envelope of glass and/or ceramic material, which envelope is composed of portions and is provided with metallic, electric connections which electrically contact the component embedded in the envelope via metal films situated between the constituent portions of the envelope characterised in that the metal films also serve as electrode layers.

A preferred embodiment of an enveloped component is characterized in accordance with the invention in that the metal films between the portions of the envelope, which serve to establish an electric connection between the component and the electric contacts, also serve as the bonding film between the portions of the envelope. In this manner, a very strong and hermetic connection between the portions of the envelope is achieved, in particular if these portions are made of glass.

These and other aspects of the invention will be apparent from and elucidated with reference to the embodiments described hereinafter.

In the drawings:
Fig. 1 is a plan view of a part of a plate which is provided with various layers;
Fig. 2 is a side view of a cross-section of the plate of Fig. 1, taken on the line II-II;
Fig. 3 is a perspective view of a component which is not et provided with electric connections;
Fig. 4 is a view of a part of the component of Fig. 3 after the removal of sharp edges;
Fig. 5 is a view of another part of the component of Fig. 3;
Fig. 6 is a side view of a component which is partly provided with a nucleation layer;
Fig. 7 is a side view of a component which is provided with electric end contacts.
Fig. 8 is a plan view of a part of a plate which is provided with blind holes as well as strips of metal foil;
Fig. 9 is a cross-sectional view of two plates arranged one on top of the other in accordance with Fig. 8, in which a diode is accommodated in the cavities;
Fig. 10 is a longitudinal cross-sectional view of an enveloped diode with electric end contacts;
Fig. 11 is a plan view of a part of a plate which is provided with through-holes;
Fig. 12 is a cross-sectional view of the plate shown in Fig. 11, taken on the line XII-XII;
Fig. 13 is a plan view of a cover plate with metal strips;
Fig. 14 is a plan view of a cover plate with metal strips;
Fig. 15 is a cross-sectional view of an assembly comprising a plate with components as well as cover plates;
Fig. 16 is a cross-sectional view of a finished enveloped component.

It is noted that the Figures are not drawn to scale. In the Figures, like reference numerals refer to like parts.

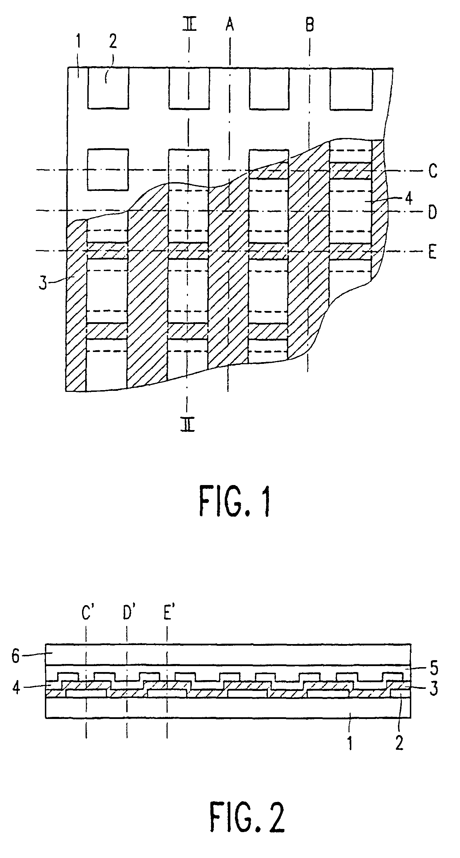

### Example 1 (Figs. 1 - 7)

A 0.3 mm thick, flat glass plate 1 is provided with a metal film, for example of aluminium, by sputtering or vapor deposition. Subsequently, a part of the aluminium film is photolithographically removed, so that the first electrode layers 2 which are arranged in a matrix remain. Next, the entire surface is provided with a dielectric layer 3 of silicon nitride by means of a chemical vapor deposition process (in Fig. 1, the layer 3 is partly removed in the left-hand top comer to show the electrode layers 2). The dielectric layer 3 is provided with a metal film of aluminium from which the electrode layers 4 are manufactured in the same manner as described hereinabove with respect to electrode layers 2, with each of the electrode layers 4 partially overlapping two underlying electrode layers 2.

Fig. 2 shows a side view of a cross-section taken on the line II-II in Fig. 1, which serves to illustrate the above-described layer structure. Subsequently, the assembly is provided with a lacquer layer 5, for example an epoxy lacquer, and the cover plate 6 of glass having a thickness of 0.2 mm is adherently provided thereon. The thickness of the assembly is slightly above 0.5 mm as the lacquer layer applied to the supporting plate 1 has a thickness of the order of several tens of microns.

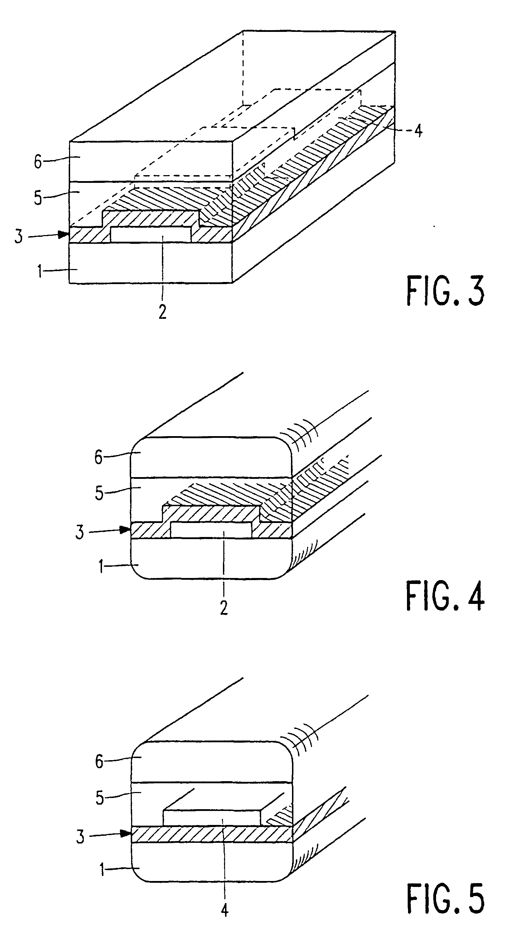

The resultant assembly is subdivided into blocks which each comprise at least one component. In the Figs. 1 and 2, a number of partition lines A, B, C, D and E, and C', D' and E', respectively, are indicated, the partition lines C, D, E and C', D', E', respectively, extending through the electrode layers 2 and 4. The subdivision into blocks is preferably carried out by sawing. Fig. 3 is a perspective view of an enveloped component prior to the provision of the electric contacts.

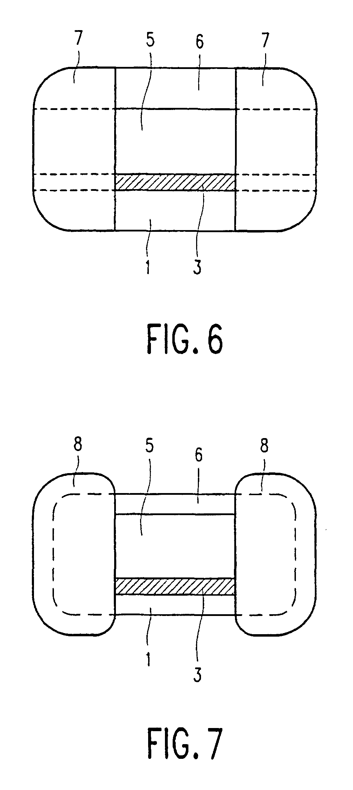

Prior to the provision of the electric contacts, the sharp edges are removed from the enveloped components, preferably by mechanical means such as tumbling. In this manner, it is precluded that during subsequent treatments in which large numbers of blocks are mechanically ordered, parts of the edges of the blocks break off. The result of this tumbling operation is shown in the Figs. 4 and 5, which show both ends of the block (component and envelope).

Subsequently, the entire block is covered with a nucleation layer of a nickel-chromium alloy by sputtering in a vacuum (barrel sputtering). The parts of the block on which, in a next step, the electric connections in the form of end contacts are to be provided are subsequently coated with a masking layer, for example of beeswax. The uncovered part of the nucleation layer is removed by etching with a suitable etchant. After removal of the masking layer, for example by means of a hot, aqueous soap solution, both ends of the block are provided with electric connections and a solder layer.

Fig. 6 is a schematic side view of a block provided with nucleation layers 7 at both ends, obtained in the indicated manner. A large number of such blocks are simultaneously provided with a first layer of copper having a thickness of the order of 1 micron by means of electrodeposition. Subsequently, in an electrodeposition process, a layer of nickel having a thickness of the order of 1 micron is provided thereon, and, next, a layer of a solder metal (PbSn) having a thickness of the order of 10 microns is applied to said nickel layer. The resultant block is shown in side view in Fig. 7, the electric end contacts provided with a solder layer being indicated by the reference numeral 8. In this manner, an enveloped, single-layer capacitor is obtained.

### Example 2

A single-layer resistor can be manufactured in the manner described in example 1, with this difference that instead of the electrically insulating dielectric layer 3 a resistance layer 3, for example of a chromium-nickel-silicon alloy is applied by means of a thin-film technique.

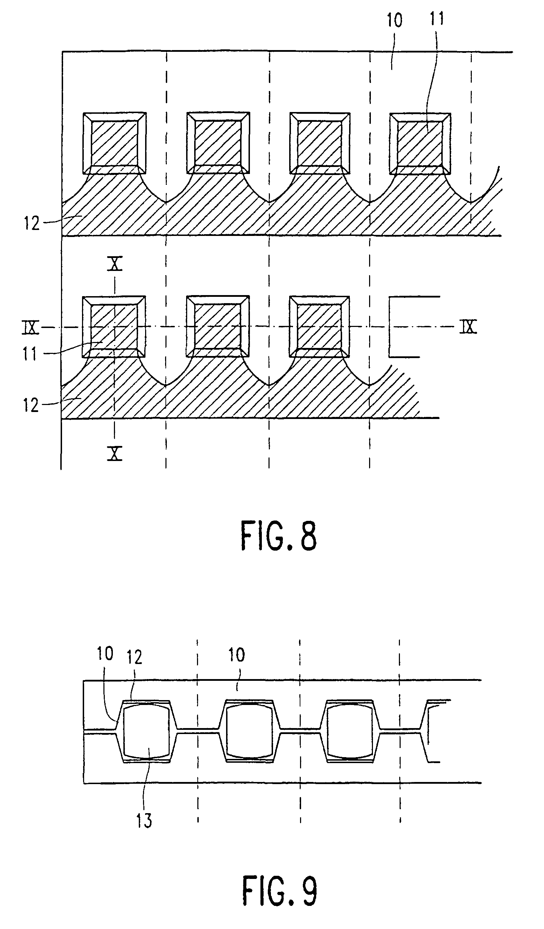

### Example 3 (Figs. 8 - 10)

Two plates 10 of glass having dimensions, for example, of 30 x 40 cm and a thickness of 0.4 mm, are provided with patterned blind holes 11 having a depth of 150 microns and an aperture at the surface of 300 x 300 microns. The openings can be formed, for example, by sand blasting using a mask provided with apertures having the desired pattern or photolithographically using an etchant. In the latter case, use can very advantageously be made of a type of glass which is marketed by SCHOTT under the trade name FOTURAN. After patterned exposure to UV light, the exposed regions of this glass can be etched selectively by means of hydrofluoric acid.

Subsequently, the surface of the plates in which the blind holes are formed is provided with a film of copper. The electrode layers 12 are formed from said copper film by means of a photolithographic process, and said electrode layers are subsequently provided with a gold layer in an electrochemical process. The cavities of plate 10 are subsequently provided with diodes 13 having dimensions, for example, of 250 x 250 x 200 microns, whereafter a second plate 10 is provided on the first plate 10. This situation is shown in Fig. 9 which is a cross-sectional view taken on the line IX-IX of Fig. 8.

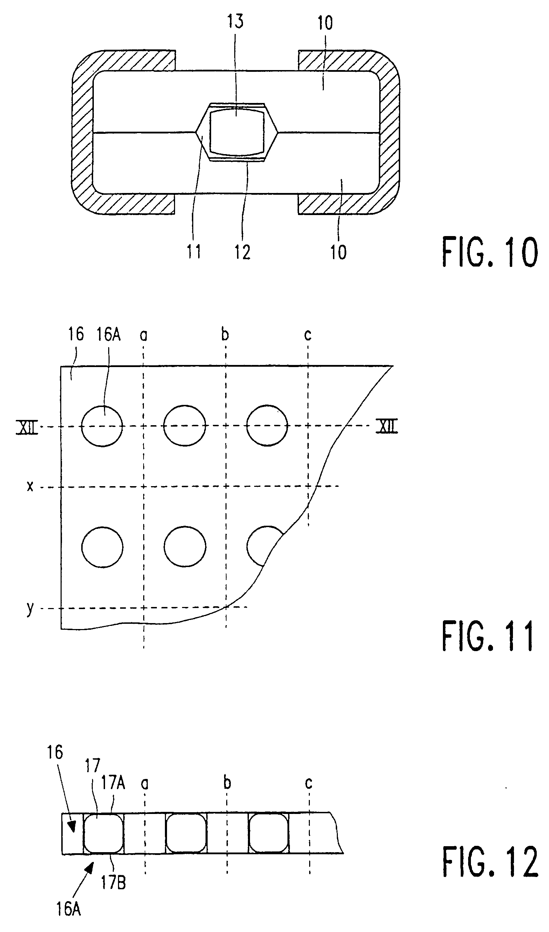

To obtain a good electric contact between the end contacts of the diodes and the metal foils on the surface of both plates 10, a small piece of gold can be sandwiched between said diodes and said metal foils (not shown). The two plates 10 are bonded together by means of a thin layer of an adhesive or by means of a glass frit. Subsequently, the assembly is subdivided into blocks and said blocks are provided with end contacts 14 and 15 in the manner indicated in example 1. Figure 10 is a cross-sectional view of a diode 13 provided with an envelope. As regards the portion of the envelope of plate 10, the cross-sectional view is taken on the line X-X in Fig. 8.

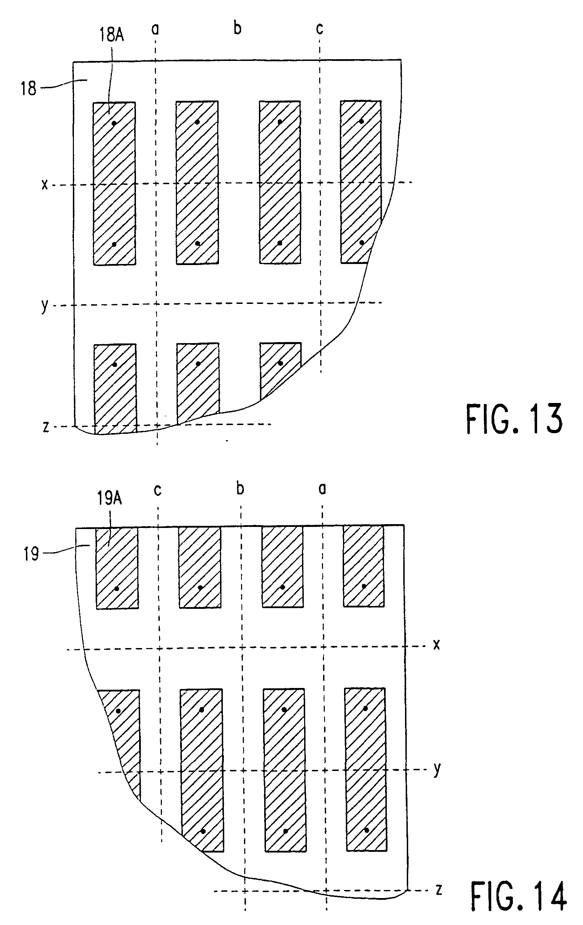

### Example 4 (Figs. 11 - 16)

A 0.6 mm thick glass plate 16 of FOTURAN is exposed to UV light via a mask. After a thermal treatment to bring about a conversion in the glass in the exposed parts of the glass plate, through-holes 16A having a diameter of 0.3 mm are formed by etching using a 10% aqueous solution of hydrogen fluoride. Components 17, for example in the form of diodes provided with two opposing end contacts 17A and 17B, are subsequently arranged in the apertures 16A.

Two cover plates 18 and 19, preferably of the same glass composition, are provided on one side with a thin copper film, for example, in an electrochemical process. Subsequently, strips 18A and 19A are formed from these films in a photolithographic process. These strips are electrochemically provided with a gold layer. The cover plates 18 and 19 are subsequently secured, with the side carrying, respectively, the metal strips 18A and 19A, to the supporting plate 16 using, for example, an epoxide resin adhesive. To improve the electric contact between the end contacts 17A and 17B of the diodes 17 and the corresponding metal strips 18A and 19B, a small quantity of gold can be sandwiched therebetween (not shown).

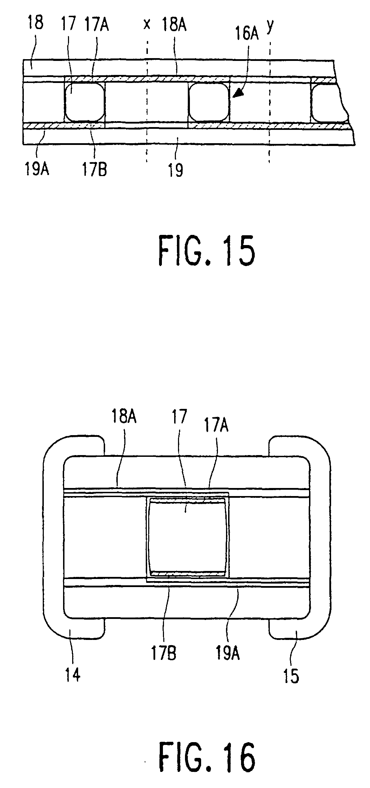

The cover plates 18 and 19 are secured to the supporting plate 16 in such a manner that the metal strips, after the subdivision into blocks in the next step of the method, project at various ends of the block. This is shown in Fig. 15, which is a cross-sectional view of the assembly prior to the subdivision into blocks. The partition lines and partition faces indicated by dotted lines x, y and z in the Figs. 11 through 15, as well as the partition lines or partition faces indicated by dotted lines a, b and c in the Figs. 11 through 14, correspond to each other. The assembly is subsequently subdivided into blocks, preferably by sawing, whereafter the end contacts are provided in the manner indicated in example 3. Fig. 16 is a cross-sectional view of a finished enveloped diode 17; the reference numerals in Fig. 16 have the same meaning as in the preceding Figures.

The cavities indicated in examples 3 and 4, are rectangular or round in cross-section. Within the scope of the invention it is alternatively possible, however, to use cavities having a different cross-sectional shape, such as triangular, elongated and such. The enveloped components shown in the examples comprise two electric end or head contacts. It will be obvious that enveloped components or combinations of equal and/or functionally different components, which may or may not be incorporated in an electric or electronic circuit, and which are provided with a common envelope in accordance with the inventive method, may comprise, if necessary, more than two such end contacts.

The enveloped components manufactured in accordance with the inventive method exhibit a very high dimensional accuracy. This has a positive effect on the placement efficiency when these components are arranged on a PCB by means of placement machines.

## Claims

1. A method of manufacturing electric, electronic or electromechanical components enveloped in electrically insulating material, **characterized in that**
(a) components (3,13,17) are provided on, or in cavities in, a plate ( 1,10,16) of an electrically insulating material,
(b) after the provision of the components (3,13,17), the plate (1,10,16) of an electrically insulating material is covered on one side, or if the components (17) are situated in through-holes (16A), on both sides with a plate (6,10,18,19) of electrically insulating material which is hermetically secured to the plate of electrically insulating material (1,10,16) supporting the components (3,13,17), thereby shutting off the components (3,13,17) from the environment, metal films (2,4,12, 18A, 19A) being applied to the surface of at least one of the plates so as to enable electric contact to be made with the components (3,13,17);
(c) the assembly is subdivided into blocks which each comprise a component (3,13,17) enveloped in electrically insulating material, with partition lines cutting into the metal films (2,4,12,18A,19A) serving to make electric contact with the components (3,13,17), and
(d) subsequently, the blocks are provided with two or more electric contacts (8,14,15) in the form of solderable metal layers which make electric contact with the metal films (2,4,12,18A,19A) projecting between the portions of the envelope, which metal films (2,4,12,18A,19A) serve to make electric contact with the enveloped component (3,13,17).

2. A method as claimed in Claim 1, **characterized in that**
(a) two plates (10) of electrically insulating material are provided with blind holes (11) in accordance with an identical pattern, the combined depth of said holes and the other dimensions being sufficient to accomodate the components (13);
(b) the plates (10) are provided with patterned electrode layers (12) in the form of strips of metal films extending down to the bottom of the cavities (11);
(c) components (13) are arranged in the cavities (11) in the plate (10), and
(d) the other plate (10) is hermetically secured, with the side provided with cavities (11) facing the side of the plate (10) comprising the components (13), to said latter plate (10), whereafter the resultant assembly is subdivided into blocks which are provided with the electric contacts (14,15).

3. A method as claimed in Claim 1, **characterized in that**
(a) a supporting plate (16) of an electrically insulating material is provided with through-holes (16A),
(b) components (17) are arranged in said holes (16A),
(c) the supporting plate (16) is covered on both sides with plates (18,19) provided with a pattern of metal strips (18A, 19A), which electrically contact the end contacts (17A, 17B) of the components (17) when the plates (18,19) are arranged on the supporting plate (16), said metal strips (18A, 19A) being arranged such that, after the subdivision into blocks in accordance with step (d), the metal strips (18A, 19A) are situation on opposite sides of the portion of the block which accomodates the component (17) in a through-hole (16A), project at opposing ends of said block between the portions of the envelope, and the assembly is subdivided into blocks which are provided with electric contacts (14,15).

4. A method as claimed in any one of claims 1 to 3, **characterized in that** after the assembly is subdivided into blocks,
(a) the sharp edges of the blocks are removed by mechanical means,
(b) the blocks are provided with a metallic nucleation layer (7),
(c) the parts of the blocks which are to be provided with a metal layer (8) in a subsequent step, are covered with the masking layer,
(d) the metallic nucleation layer (7) is removed from the parts which are not covered with a masking layer,
(e) the masking layer is removed,
(f) the exposed nucleation layer (7) is provided with a metal layer (8) and a solder layer which embrace the block.

5. A method as claimed in claim 1 to 4, **characterized in that** a combination of equal and/or functionally different components is provided and encapsulated into one common envelope having electric contacts (8,14,15).

6. An enveloped, electric, electronic or electromechanical component (3,13,17), that is embedded in a hermetic envelope of electrically insulating material, which envelope is composed of portions and is provided with metallic electric contacts (8,14,15) that electrically contact the component (3,13,17) embedded in the envelope via metal films (2,4,12,18A,19A) situated between the constituent portions of the envelope,
**characterized in that** the metal films (2,4,12,18A,19A) also serve as electrode layers.

7. An enveloped component as claimed in Claim 6, **characterized in that** the metal films (2,4,12,18A,19A) between the portions of the envelope, which serve to establish an electric connection between the component (3,13,17) and the electric contacts (8,14,15), also serve as the bonding film between the portions of the envelope.

8. An enveloped combination of equal and/or functionally different components (3,13,17) incorporated in an electric or electronic circuit, which combination is embedded in a hermetic envelope of electrically insulating material, which envelope is composed of portions and is provided with metallic electric contacts (8,14,15) that electrically contact the combination of components (3,13,17) embedded in the envelope via metal films (2,4,12,18A,19A) situated between the constituent portions of the envelope,
**characterized in that** a metal film (2,4,12,18A,19A) is provided as electroconductive tracks in accordance with a suitable pattern so as to act as electroconductive wiring for the circuit.

9. An enveloped component or combination as claimed in Claim 6 or 8, **characterized in that** the hermetic envelope comprises glass and/or ceramic material.

## Patentansprüche

1. Verfahren zum Herstellen elektrischer, elektronischer oder elektromechanischer, von elektrisch isolierendem Material umhüllter Bauelemente, **dadurch gekennzeichnet, dass**
(a) Bauelemente (3, 13, 17) auf oder in Hohlräumen in einer Platte (1, 10, 16) aus einem elektrisch isolierenden Material vorgesehen werden,
(b) nach der Anordnung der Bauelemente (3, 13, 17) die Platte (1, 10, 16) aus einem elektrisch isolierenden Material auf nur einer Seite bedeckt wird, oder wenn die Bauelemente (17) in Durchführungen (16A) liegen, auf beiden Seiten mit einer Platte (6, 10, 18, 19) aus elektrisch isolierendem Material bedeckt wird, wobei diese Platte an der Platte aus elektrisch isolierendem Material (1, 10, 16), welche die Bauelemente (3, 13, 17) trägt, hermetisch dicht befestigt wird wodurch die Bauelemente (3, 13, 17) gegenüber der Umgebung eingeschlossen sind, wobei an der Oberfläche wenigstens einer der Platten Metallfilme (2, 4, 12, 18A, 19A) angebracht werden, damit mit den Bauelementen (3, 13, 17) elektrischer Kontakt gemacht werden kann;
(c) das Gebilde in Blöcke aufgeteilt wird, die je ein in elektrisch isolierendem Material eingeschlossenes Bauelement (3, 13, 17) enthalten, wobei Trennlinien in den Metallfilme (2, 4, 12, 18A, 19A) geschnitten werden, die dazu dienen mit den Bauelementen (3, 13, 17) elektrischen Kontakt zu machen, und
(d) daraufhin die Blöcke mit zwei oder mehr elektrischen Kontakten (8, 14, 15) in Form lötbarer Metallschichten versehen werden, die mit den Metallfilmen (2, 4, 12, 18A, 19A), die zwischen die Teile der Umhüllung hervorragen, elektrischen Kontakt machen, wobei diese Metallfilme (2, 4, 12, 18A, 19A) dazu dienen, mit dem umhüllten Bauelement (3, 13, 17) elektrischen Kontakt zu machen.

2. Verfahren nach Anspruch 1, **dadurch gekennzeichnet, dass**
(a) zwei Platten (10) aus elektrisch isolierendem Material entsprechend einem identischen Muster mit Sacklöchern (11) versehen werden, wobei die kombinierte Tiefe der genannten Löcher und die anderen Abmessungen ausreichen um die Bauelemente (13) aufzunehmen;
(b) die Platten (10) mit mit einem Muster versehenen Elektrodenschichten (12) in Form von Streifen aus Metallfilmen versehen werden, die sich bis an den Boden der Hohlräume (11) erstrecken;
(c) Bauelemente (13) in den Hohlräumen (11) in der Platte (10) vorgesehen sind, und
(d) die andere Platte (10) an der weiteren Platte (10) hermetisch befestigt wird, wobei die Seite, die mit Hohlräumen (11) versehen ist, derjenigen Seite der Platte (10) zugewandt ist, welche die Bauelemente (13) enthält, wonach das resultierende Gebilde in Blöcke aufgeteilt wird, die mit elektrischen Kontakten (14, 15) versehen werden.

3. Verfahren nach Anspruch 1, **dadurch gekennzeichnet, dass**
(a) eine Trägerplatte (16) aus einem elektrisch isolierenden Material mit hindurchgehenden Löchern (16A) versehen wird,
(b) Bauelemente (17) in den genannten Löchern (16A) vorgesehen werden,
(c) die Trägerplatte (16) an beiden Seiten mit Platten (18, 19) bedeckt wird, die mit einem Muster aus Metallstreifen (18A, 19A) versehen sind, welche die Endkontakte (17A, 17B) der Bauelemente (17) elektrisch Kontaktieren, wenn die Platten (18, 19) auf der Trägerplatte (16) vorgesehen werden, wobei die genannten Metallstreifen (18A, 19A) derart vorgesehen werden, dass nach der Aufteilung in Blöcke entsprechend dem Verfahrensschritt (d) die Metallstreifen (18A, 19A) an einander gegenüber liegenden Seiten des Teils des Blocks liegen, der das Beauelement (17) in einem hindurchgehenden Loch (16A) enthält, an einander gegenüber liegenden Enden des genannten Blocks zwischen den Teilen der Umhüllung hervorragen und das Gebilde in Blöcke aufgeteilt wird, die mit elektrischen Kontakten (14, 15) versehen sind.

4. Verfahren nach einem der Ansprüche 1 bis 3, **dadurch gekennzeichnet, dass** nachdem das Gebilde in Blöcke aufgeteilt worden ist,
(a) die scharfen Kanten der Blöcke mit Hilfe mechanischer Mittel entfernt werden,
(b) die Blöcke mit einer metallischen Keimbildungsschicht (7) versehen werden,
(c) die Teile der Blöcke, die in einem nachfolgenden Schritt mit einer Metallschicht (8) versehen werden sollen, mit der Maskierungsschicht bedeckt werden,
(d) die metallische Keimbildungsschicht (7) von denjenigen Teilen entfernt wird, die nicht mit einer Maskierungsschicht bedeckt sind,
(e) die Maskierungsschicht entfernt wird,
(f) die freigelegte Keimbildungsschicht (7) mit einer Metallschicht (8) und einer Lötschicht versehen wird, die den Block einschließt.

5. Verfahren nach Anspruch 1 bis 4, **dadurch gekennzeichnet, dass** eine Kombination aus gleichen und/oder funktionell verschiedenen Bauelementen vorgesehen und in eine gemeinsame Umhüllung mit elektrischen Kontakten (8, 14, 15) eingekapselt wird.

6. Umhülltes, elektrisches, elektronisches oder elektromechanisches Bauelement (3, 13, 17), das in eine hermetische Hülle aus elektrisch isolierendem Material eingebettet wird, wobei diese Umhüllung aus Teilen besteht und mit metallischen, elektrischen Kontakten (8, 14, 15) versehen ist, die das in die Hülle eingebettete Bauelement über Metallfilme (2, 4, 12, 18A, 19A) zwischen den bildenden Teilen der Hülle kontaktieren, **dadurch gekennzeichnet, dass** die Metallfilme (2, 4, 12, 18A, 19A) ebenfalls als Elektrodenschicht wirksam sind.

7. Umhülltes Bauelement nach Anspruch 6, **dadurch gekennzeichnet, dass** die Metallfilme (2, 4, 12, 18A, 19A) zwischen den Teilen der Hülle, die dazu dienen, zwischen dem Bauelement (3, 13, 17) und den elektrischen Kontakten (8, 14, 15) eine elektrische Verbindung zu bilden, auch als Verbindungsfilm zwischen den Teilen der Umhüllung wirksam sind.

8. Umhüllte Kombination gleicher und/oder funktionell verschiedener Bauelemente (3, 13, 17) vereint in einer elektrischen oder elektronischen Schaltungsanordnung, wobei diese Kombination in eine hermetische Hülle aus elektrisch isolierendem Material eingebettet ist, wobei diese Hülle aus Teilen besteht und mit metallischen elektrischen Kontakten (8, 14, 15) versehen ist, welche die Kombination in die Hülle eingebetteter Bauelemente (3, 13, 17) über Metallfilme (2, 4, 12, 18A, 19A), die sich zwischen den bildenden Teilen der Hülle befinden, elektrisch kontaktieren, **dadurch gekennzeichnet, dass** ein Metallfilm (2, 4, 12, 18A, 19A) als elektrisch leitende Spuren entsprechend einem geeigneten Muster vorgesehen ist, damit dieses Muster als elektrisch leitende Verdrahtung für die Schaltungsanordnung wirksam sein kann.

9. Umhülltes Bauelement oder umhüllte Kombination nach Anspruch 6 oder 8, **dadurch gekennzeichnet, dass** die hermetische Umhüllung Glas und/oder keramisches Material enthält.

## Revendications

1. Procédé pour fabriquer des composants électriques, électroniques ou électromécaniques qui sont enveloppés dans un matériau électriquement isolant, **caractérisé en ce que**
(a) des composants (3, 13, 17) sont appliqués sur, ou dans des cavités dans, une plaque (1, 10, 16) constituée d'un matériau électriquement isolant,
(b) après l'application des composants (3, 13, 17), la plaque (1, 10, 16) constituée d'un matériau électriquement isolant est recouverte d'un seul côté, ou si les composants (17) se situent dans des trous traversants (16A), des deux côtés d'une plaque (6, 10, 18, 19) constituée de matériau électriquement isolant qui est fixée hermétiquement à la plaque (1, 10, 16) constituée d'un matériau électriquement isolant qui appuie les composants (3, 13, 17), de ce fait fermant les composants (3, 13, 17) de l'environnement, des films métalliques (2, 4, 12, 18A, 19A) étant appliqués sur la surface d'au moins une des plaques de manière à permettre le contact électrique avec les composants (3, 13, 17),
(c) l'ensemble est subdivisé en des blocs qui comprennent chacun un composant (3, 13, 17) étant enveloppé dans un matériau électriquement isolant, des lignes de division coupant dans les films métalliques (2, 4, 12, 18A, 19A) servant à faire contact électrique avec les composants (3, 13, 17), et
(d) ensuite, les blocs sont pourvus de deux ou de plusieurs contacts électriques (8, 14, 15) sous la forme de couches métalliques soudables qui font contact électrique avec les films métalliques (2,4,12,18A, 19A) faisant saillie entre les portions de l'enveloppe, lesquels films métalliques (2, 4, 12, 18A, 19A) servent à faire contact électrique avec le composant enveloppé (3, 13, 17).

2. Procédé selon la revendication 1, **caractérisé en ce que**
(a) deux plaques (10) constituées d'un matériau électriquement isolant sont pourvues de trous borgnes (11) selon une configuration identique, la profondeur combinée desdits trous et les autres dimensions étant suffisantes pour faire place au composant (13),
(b) les plaques (10) sont pourvues de couches d'électrode (12) mises en configuration sous la forme de bandes de films métalliques s'étendant jusqu'au fond des cavités (11),
(c) des composants (13) sont disposés dans les cavités (11) présentes dans la plaque (10), et
(d) l'autre plaque (10) est fixée hermétiquement, le côté étant pourvu de cavités (11) qui se situent vis-à-vis du côté de la plaque (10) comprenant les composants (13), à ladite dernière plaque (10), après quoi l'ensemble ainsi obtenu est subdivisé en des blocs qui sont pourvus des contacts électriques (14, 15).

3. Procédé selon la revendication 1, **caractérisé en ce que**
(a) une plaque d'appui (16) constituée d'un matériau électriquement isolant est pourvue de trous traversants (16A),
(b) des composants (17) sont disposés dans lesdits trous (16A),
(c) la plaque d'appui (16) est recouverte, des deux côtés, de plaques (18, 19) étant pourvues d'une configuration de bandes métalliques (18A, 19A) qui viennent en contact électrique avec les contacts terminaux (17A, 17B) des composants (17) lorsque les plaques (18, 19) sont disposées sur la plaque d'appui (16), lesdites bandes métalliques (18A, 19A) étant disposées de telle façon que, après la subdivision en des blocs selon l'étape (d), les bandes métalliques (18A, 19A) se situent des côtés opposés de la portion du bloc qui fait place au composant (17) dans un trou traversant (16A), fassent saillie à l'endroit d'extrémités opposées du bloc entre les portions de l'enveloppe et que l'ensemble soit subdivisé en des blocs qui sont pourvus de contacts électriques (14, 15).

4. Procédé selon l'une quelconque des revendications 1 à 3, **caractérisé en ce qu'**après la subdivision de l'ensemble en des blocs,
(a) les bords aigus des blocs sont enlevés par des moyens mécaniques,
(b) les blocs sont pourvus d'une couche de nucléation métallique (7),
(c) les parties des blocs qui doivent être pourvus d'une couche métallique (8) dans une étape subséquente sont recouvertes d'une couche de masquage,
(d) la couche de nucléation métallique (7) est enlevée des parties qui ne sont pas recouvertes d'une couche de masquage,
(e) la couche de masquage est enlevée,
(f) la couche de nucléation exposée (7) est pourvue d'une couche métallique (8) et d'une couche de soudure qui embrassent le bloc.

5. Procédé selon l'une quelconque des revendications précédentes 1 à 4, **caractérisé en ce qu'**une combinaison de composants égaux et/ou fonctionnellement différents sont appliqués et sont encapsulés dans une enveloppe commune ayant des contacts électriques (8, 14, 15).

6. Composant électrique, électronique ou électromécanique enveloppé (3, 13, 17) qui est encastré dans une enveloppe hermétique constituée de matériau électriquement isolant, laquelle enveloppe se compose de portions et est pourvue de contacts électriques métalliques (8, 14, 15) qui viennent en contact électrique avec le composant (3, 13, 17) étant encastré dans l'enveloppe par le biais de films métalliques (2, 4, 12, 18A, 19A) qui se situent entre les portions constitutives de l'enveloppe, **caractérisé en ce que** les films métalliques (2, 4, 12, 18A, 19A) font également fonction de couches d'électrode.

7. Composant enveloppé selon la revendication 6, **caractérisé en ce que** les films métalliques (2, 4, 12, 18A, 19A) entre les portions de l'enveloppe, qui servent à réaliser une connexion électrique entre le composant (3, 13, 17) et les contacts électriques (8, 14, 15) font également fontion de film adhésif entre les portions de l'enveloppe.

8. Combinaison enveloppée de composants égaux et/ou fonctionnellement différents (3, 13, 17) qui sont incorporés dans un circuit électrique ou électronique, laquelle combinaison est encastrée dans une enveloppe hermétique constituée de matériau électriquement isolant, laquelle enveloppe se compose de portions et est pourvue de contacts électriques métalliques (8, 14, 15) qui viennent en contact électrique avec la combinaison de composants (3, 13, 17) étant encastrés dans l'enveloppe par le biais de films métalliques (2, 4, 12, 18A, 19A) qui se situent entre les portions constitutives de l'enveloppe, **caractérisée en ce qu'**un film métallique (2, 4, 12, 18A, 19A) est appliqué en tant que des pistes électroconductrices selon une configuration appropriée de manière à faire fonction de câblage électroconducteur pour le circuit.

9. Composant enveloppé ou combinaison selon la revendication 6 ou 8, **caractérisée en ce que** l'enveloppe hermétique comprend du verre et/ou du matériau céramique.
